# EUROPÄISCHE PATENTSCHRIFT

(11) **EP 1 430 530 B1**
(45) Veröffentlichungstag und Bekanntmachung des Hinweises auf die Patenterteilung: **02.09.2009**
(21) Anmeldenummer: 02729838.9
(22) Anmeldetag: 30.03.2002
(51) Int. Cl.: H01L 23/473, H01L 23/373, F28F 13/00

(54) **WÄRMETAUSCHER**
HEAT EXCHANGER
ECHANGEUR DE CHALEUR

(30) Priorität: 14.05.2001 DE 10123456; 22.02.2002 DE 10207671
(43) Veröffentlichungstag der Anmeldung: 23.06.2004
(73) Patentinhaber: m.pore GmbH, 01277 Dresden (DE)
(72) Erfinder: GIRLICH, Dieter, 01309 Dresden (DE); KÜHN, Carsten, 55595 Bockenau (DE); SCHÄDLICH-STUBENRAUCH, Jürgen, NL-6291 CN Vaals (NL)
(74) Vertreter: Kaufmann, Sigfrid
(86) Internationale Anmeldenummer: PCT/DE2002/001181
(87) Internationale Veröffentlichungsnummer: WO 2002/093644

(56) Entgegenhaltungen:
- EP-A- 0 471 552
- WO-A-01/69160
- DE-A- 19 650 613
- DE-A- 19 653 956
- DE-A- 19 952 314
- FR-A- 2 742 856
- JP-A- 50 154 853
- JP-A- 51 023 848
- US-A- 5 145 001
- US-A- 5 914 856
- US-B1- 6 196 307
- PATENT ABSTRACTS OF JAPAN vol. 007, no. 236 (E-205), 20. Oktober 1983 (1983-10-20) -& JP 58 125855 A (MATSUSHITA DENKO KK), 27. Juli 1983 (1983-07-27)
- BASTAWROS A -F ET AL: "Characterisation of open-cell aluminum alloy foams as heat sinks for high power electronic devices" , CAE/CAD AND THERMAL MANAGEMENT ISSUES IN ELECTRONIC SYSTEMS. 1997 ASME INTERNATIONAL MECHANICAL ENGINEERING CONGRESS AND EXPOSITION, CAE/CAD AND THERMAL MANAGEMENT ISSUES IN ELECTRONIC SYSTEMS. ASME INTERNATIONAL MECHANICAL ENGINEERING CONGRESS AND E , 1997, NEW YORK, NY, USA, ASME, USA, PAGE(S) 1 - 6 XP008012562 ISBN: 0-7918-1852-7 das ganze Dokument

## Beschreibung

Die Erfindung betrifft einen Wärmetauscher.

Wärmetauscher sind Vorrichtungen, die Wärme von einem fließenden Medium mit höherer Temperatur auf ein fließendes Medium mit niedrigerer Temperatur übertragen, wobei sich das wärmere Medium abkühlt, während sich das kältere Medium erwärmt. In Abhängigkeit vom Anwendungszweck sind unterschiedliche technische Gestaltungen von Wärmetauschern bekannt.

Für einen effektiven Wärmeaustausch zwischen den Medien ist es erforderlich, eine möglichst große Austauschfläche zur Verfügung zu stellen. Zu diesem Zweck weisen Wärmetauscher Kühlkörper mit Rippenprofil und Bandwiclklungen auf. Der Kontakt zwischen einem solchen Kühlkörper und einem strömenden Medium wird über Rohre oder ähnliches hergestellt, die mit dem Kühlkörper mechanisch verbunden sind. Derartige Verbindungen, die durch Pressen, Kleben oder Fügen wie beispielsweise Löten hergestellt wurden, haben jedoch den Nachteil, daß Barrieren für den Wärmefluß entstehen. Überdies ist der Materialeinsatz hoch. Die Kühlleistung ist für die meist aus Aluminium gefertigten Wärmetauscher durch das maximal erzielbare Verhältnis von Oberfläche zu Volumen begrenzt. Die Kontaktkorrosion zwischen unterschiedlichen Materialien führt zu Leckagen. Außerdem sind gepreßte Verbindungen mechanisch nicht stark belastbar.

Aus EP 0 559 092 ist ein Wärmeableiter für Halbleiterbauelemente bekannt, der einen Wärmeverteiler umfaßt. Dieser Wärmeverteiler ist auf der Oberfläche des Halbleiterbauelements befestigt. Auf dem Wärmeverteiler ist ein Metallschaum angeordnet. Der Metallschaum ist auf dem Wärmeverteiler mit einem wärmeleitenden Haftmittel befestigt. Alternativ wird der Metallschaum auf den Wärmeverteiler aufgelötet. Auch dieser Wärmetauscher weist somit die vorstehend beschriebenen Nachteile auf.

US 6,196,307 offenbart einen Metallschaumblock, der in einer wärmeleitenden Beziehung mit einem Elektronikmodul positioniert ist. Der Metallschaumblock weist eine flache Oberfläche auf, so daß er auf die ebenfalls flache Oberfläche eines Elektronikmoduls aufgebracht werden kann. Der Metallschaumblock enthält zufällig verteilte Porenzellen, die miteinander verbunden sind, so daß ein Kühlmittel im wesentlichen parallel zu der flachen Oberfläche des Elektronikmoduls durch den Metallschaum fließen kann. Die Stege, die die Porenzellen begrenzen, verlaufen im wesentlichen senkrecht zu der flachen Oberfläche des Elektronikmoduls, so daß eine höhere Metalldichte in den senkrecht zu der beabsichtigten Richtung des Wärmeflusses stehenden Querschnittsebenen des Metallschaums vorhanden ist. Der unter Verwendung dieses Metallschaumblocks gebildete Wärmetauscher umfaßt weiterhin eine thermische Grundplatte aus einem Metall, einem Metallmatrixkomposit oder einer Keramik. Die dem Metallschaum zugewandte-Seite der Grundplatte ist mit einer Metallschicht bedeckt, damit eine direkte Bindung zwischen der thermischen Grundplatte und dem Metallschaumblock möglich ist. Weiterhin umfaßt der Wärmeaustauscher ein Gehäuse, der den Metallschaumblock an den übrigen Seiten umschließt, wobei das Gehäuse Zu- und Ableitungen für das Kühlmittel aufweist. Der in US 6,196,307 offenbarte Wärmeaustauscher weist somit ebenfalls die bereits beschriebenen Nachteile auf.

Die US 5,145,001 offenbart einen weiteren Wärmetauscher aus porösem Metallschaum.

Es ist daher Ziel der vorliegenden Erfindung, die oben beschriebenen Nachteile des Standes der Technik zu überwinden. Dabei steht die Aufgabe, einen verbesserten Wärmetauscher vorzuschlagen. Insbesondere soll ein Wärmetauscher angegeben werden, der einen verbesserten Wärmeaustausch ermöglicht.

Diese Aufgabe wird durch die Merkmale des Anspruchs 1 gelöst. Zweckmäßige Ausgestaltungen der Erfindung ergeben sich aus den Merkmalen der abhängigen Ansprüche.

Erfingdungsgemäß wird somit ein Wärmetauscher zur Verfügung gestellt, der aus offenporigem Metallschaum besteht, wobei zumindest ein Teil der in dem Metallschaum enthaltenen Zellen miteinander verbunden ist, so daß ein fluides Medium durch den Metallschaum hindurch fließen kann.

Infolge der Fertigung des Wärmetauschers aus offenporigem Metallschaum werden Wärmetauscher erhalten, die sich durch geringes Gewicht aufgrund eines Materialanteils von fünf Prozent pro Volumeneinheit, hohe innere Oberfläche, Durchströmbarkeit, hohe geometrische Gestaltungsmöglichkeiten und eine breite Materialauswahl auszeichnet.

Der vorgeschlagene Wärmetauscher unterscheidet sich somit von dem in EP 0 559 092 vorgeschlagen Wärmeableiter dahingehend, daß der gesamte Wärmetauscher aus Metallschaum gefertigt ist. Die Bildung eines Wärmetauschers aus mehreren Bauelementen, die miteinander unter in Kaufnahme der vorstehend erläuterten Nachteile verbunden werden müssen, wird so vermieden.

Der aus offenporigem Metallschaum gebildete Wärmetauscher überträgt die Wärmeenergie aus dem zu kühlenden Medium, das sich mit dem Wärmetauscher in Kontakt befindet. Dazu wird das zu kühlende Medium in der offenporigen Struktur des Metallschaums transportiert, wobei Turbulenzen erzeugt werden. Die Turbulenz ermöglicht einen besseren Wärmeübergang von dem Medium auf den offenporigen Metallschaum, der aufgrund seiner geringen Masse für eine schnelle gleichmäßige Verteilung der Wärmeenergie sorgt. Dabei erfolgt die Wärmeableitung ungerichtet. Der Strömungswiderstand des Metallschaums kann über die Anzahl der Poren eingestellt werden. Zur Vermeidung von Korrosion wird das Wärmetauschermaterial in Abhängigkeit von dem zu kühlenden Medium gewählt. Ein Verfahren zur Herstellung von Metallschäumen wird in DE 199 39 155 offenbart.

Der offenporige Metallschaum kann als Behältereinsatz, als Schüttung von Granalien zur gleichmäßigen Wärmeverteilung (Sorptionsprozeß) oder zur Vermeidung lokaler Überhitzungen, beispielsweise bei radioaktiven Stoffen, verwendet werden.

Zur weiteren Verbesserung des Wirkungsgrades des Wärmetauschers kann sich das Volumen der in dem Metallschaum enthaltenen Zellen mit zunehmender Entfernung vom Eintrittsort des abzuführenden Wärmestromes in den Metallschaum verändern, wodurch eine Gradierung erreicht wird. Je nach Anwendungszweck, das heißt beispielsweise in Abhängigkeit von der Temperaturdifferenz oder der Geschwindigkeit des Wärmeabtransportes, kann das Zellvolumen zunehmen oder abnehmen. Gleichzeitig oder alternativ kann die Wandstärke der zwischen den Zellen befindlichen Metallstege mit zunehmender Entfernung vom Eintrittsort des abzuführenden Wärmestromes abnehmen.

Die Form des Wärmetauschers ist sehr variabel, das heißt, der Metallschaum kann in jeder geeigneten Form gegossen werden. Beispielsweise kann der Wärmetauscher eine quader-, würfel-, rohrförmige oder kammartige Gestalt aufweisen. Es ist ebenso möglich, daß der Wärmetauscher mehrere Segmente aufweist, die aus dem offenporigen Metallschaum gebildet sind. Die Segmente sind zweckmäßigerweise miteinander verbunden.

Der Wärmetauscher kann weitere, mit dem offenporigen Metallschaum in Verbindung stehende Bauelemente aufweisen, wobei die Bauelemente und der offenporige Metallschaum in einem Stück gegossen sind, so daß die Bauelemente stoffschlüssig mit dem Metallschaum verbunden sind. Auf diese Weise wird es möglich, komplexere Wärmetauscher zu fertigen. Diese weisen jedoch nicht die Nachteile bekannter Wärmetauscher auf, da aufgrund der Herstellung aller Bauelemente und des offenporigen Metallschaums aus demselben Material und der aufgrund des gemeinsamen Gießens fehlenden Notwendigkeit, die Bauelemente nachträglich miteinander mechanisch zu verbinden, Barrieren für den Wärmefluß und Leckagen infolge von Kontaktkorrosion vermieden oder zumindest reduziert werden. Überdies verringert sich der Materialeinsatz zur Herstellung des Wärmetauschers, und seine Belastbarkeit ist deutlich höher. Überdies können kompaktere Wärmetauscher hergestellt werden, die trotzdem eine vergleichsweise große Oberfläche in bezug auf ihr Volumen aufweisen.

Die Bauelemente können beispielsweise Rohre für fluide Medien, Trennwände, die den Metallschaum in Kammern unterteilen, oder Außenwände sein. Die Trenn- und Außenwände können plattenförmig ausgestaltet sein. Die Bauelemente selbst können auch strukturiert sein. Die Rohre können ebenfalls mit offenporigem Metallschaum gefüllt sein, um die Oberfläche zu vergrößern, die Anzahl der Rohre zu verringern und die Strömungsgeschwindigkeit zu reduzieren. Wesentlich dabei ist, daß die Rohre und/oder Platten an den Metallschaum angegossen oder in diesen eingegossen sind.

Die Rohre und Wände können die wärmeaustauschenden Medien trennen, wodurch die Strömungsrichtung der Medien gegeneinander eingestellt werden kann. Durch geeignete Anordnung der Trennwände kann erreicht werden, daß fluide Medien im Gegenstrom durch den offenporigen Metallschaum geführt werden.

Die Erfindung erlaubt somit, in kompakter Bauweise effiziente Wärmetauscher herzustellen, die besser auf ihre jeweilige Anwendung hinsichtlich Materialauswahl und Geometrie angepaßt werden können.

Beispielsweise erlaubt es die Erfindung, eine Kühlvorrichtung für Transistoren mit hohem Wirkungsgrad herzustellen, da die Kühlvorrichtung unmittelbar auf die Transistoroberfläche aufgebracht wird, ohne daß Bauelemente aus anderen Materialien benötigt werden, der Metallschaum, der die Kühlvorrichtung bildet, strukturiert ist und gegebenfalls eine Gradierung aufweist. Überdies entfällt im Vergleich zu bekannten Kühlvorrichtungen für Transistoren, die aus im wesentlichen parallel verlaufenden Lamellen bestehen, die Notwendigkeit, die Kühlvorrichtung in bezug auf die zirkulierende Luft auszurichten.

In einer bevorzugten Ausführungsform ist der Wärmetauscher aus mehreren Bauteilen gebildet, die jeweils aus Bauelementen wie Rohren oder Platten bestehen, und aus offenporigem Metallschaum bestehen. Diese Bauteile sind zweckmäßigerweise miteinander verbunden. Auf diese Weise wird ein modularer Aufbau der Wärmetauscher erreicht, so daß er im Gleichstrom, Gegenstrom oder Kreuzstrom betrieben werden kann.

Zudem ist nach Maßgabe der Erfindung ein Wärmetauscher vorgesehen, der aus offenporigem Metallschaum und zumindest einem Wärmeverteiler besteht, der an den Metallschaum stoffschlüssig angebunden ist, wobei die dem Metallschaum abgewandte Oberfläche des Wärmeverteilers strukturiert ist.

Der stoffschlüssig angebundene Wärmeverteiler stellt eine große Fläche für die Wärmeübertragung auf den offenporigen Metallschaum zur Verfügung, ohne die Wärmeübertragung zu beeinträchtigen. Die Strukturierung der Oberfläche des Wärmeverteilers, die dem Metallschaum abgewandt ist, führt zu einer Vergrößerung dieser Oberfläche des Wärmeverteilers, so daß Wärme effizienter in den Metallschaum geleitet wird. Durch die Strukturierung der Oberfläche vermindert sich außerdem das Gewicht des Wärmeverteilers und damit des Wärmetauschers insgesamt. Der. Wärmetauscher ist überdies kompakter gestaltet.

Die geometrische Form des Wärmetauschers ist sehr variabel, der Metallschaum kann in einer für den jeweiligen Anwendungszweck geeigneten Form hergestellt werden. Der Wärmetauscher kann eine quader-, würfel-, rohrförmige oder kammartige Gestalt aufweisen. Der Wärmetauscher kann außerdem mehrere Segmente aufweisen.

Vorzugsweise ist die Oberfläche des Wärmeverteilers derart strukturiert, daß kanalförmige Strukturen auf der Oberfläche des Wärmeverteilers ausgebildet sind. Durch diese kanalartigen Strukturen kann beispielsweise ein flüssiges Medium geführt werden. In die kanalförmigen Strukturen auf der Oberfläche des Wärmetauschers können allerdings auch Rohre, beispielsweise durch Löten, Pressen oder Kleben eingebracht werden.

Zweckmäßigerweise ist der Wärmeverteiler als Platte oder Steg ausgebildet. Der Ausdruck "Steg" ist in diesem Zusammenhang als Element mit vergleichsweise kleiner Oberfläche zu verstehen, der nur einen geringen Teil der Metallschaumoberfläche bedeckt. Die Oberfläche eines solchen Steges kann beispielsweise eine Strukturierung in Form eines einzelnen Kanals aufweisen. Der Metallschaum weist zweckmäßigerweise mehrere solche Stege auf. Der Ausdruck "Platte" soll darauf hinweisen, daß der Wärmeverteiler einen größeren Teil der Oberfläche oder eine gesamte Außenfläche des Metallschaums bedeckt, wobei die Oberfläche des Wärmeverteilers kompliziertere Strukturen aufweisen kann. Der Wärmeverteiler kann aus mehreren Stegen, mehreren Platten oder einer Kombination aus einer oder mehreren Platten und einem oder mehreren Stegen bestehen.

Der Wärmeverteiler besteht zweckmäßiger aus Metall, das im wesentlichen porenfrei ist, d. h. aus sogenanntem "Vollmetall". Geeignete Metalle für diesen Zweck sind beispielsweise Aluminium, Kupfer oder Stahl. Der Metallschaum sollte aus Aluminium gebildet sein. Die Strukturierung der Oberfläche des Verteilers kann durch mechanische oder ähnliche abrasive Bearbeitungsmethoden beispielsweise unter Verwendung eines Lasers vorgenommen werden.

Die Strukturierung in den Stegen und Platten kann in der geometrischen Gestaltung weit über die Möglichkeiten hinausgehen, die mit Rohren zu erzielen sind. Biegeradien stellen somit keine Beschränkung mehr dar. Die Verästelung der Struktur in der Oberfläche des Wärmeverteilers kann sehr fein und dreidimensional erfolgen. Eine noch feinere Strukturierung kann erreicht werden, indem in die bereits ausgebildeten Konturen Beschichtungen eingebracht werden. Die flächige Ausnutzung für den Wärmetausch kam dadurch optimiert werden.

Der Wärmeverteiler kann weiterhin mit einer Deckschicht verbunden sein, die die strukturierte Oberfläche des Wärmeverteilers überdeckt. Das Deckelement kann als einfache Platte ausgeführt sein. Alternativ kann die dem Wärmeverteiler zugewandete Oberfläche der Deckschicht eine zu der Strukturen in der Oberfläche des Wärmeverteilers spiegelbildliche Struktur aufweisen. Es ist allerdings auch möglich, daß die dem Wärmeverteiler zugewandete Oberfläche der Deckschicht eine feinere Struktur als der Wärmverteiler aufweist. Diese feinere Strukturierung kann innerhalb der im wesentlichen spiegelbildlich ausgeprägten Struktur der Deckschicht vorliegen.

Die Deckschicht besteht zweckmäßigerweise aus demselben Material wie der Wärmeverteiler. Die Verbindung der Deckschicht mit dem Wärmeverteiler kann beispielsweise durch Verlöten oder Verkleben hergestellt sein.

Im folgenden wird die Erfindung anhand von Ausführungsbeispielen mit Bezug auf die beiliegenden Zeichnungen näher erläutert.

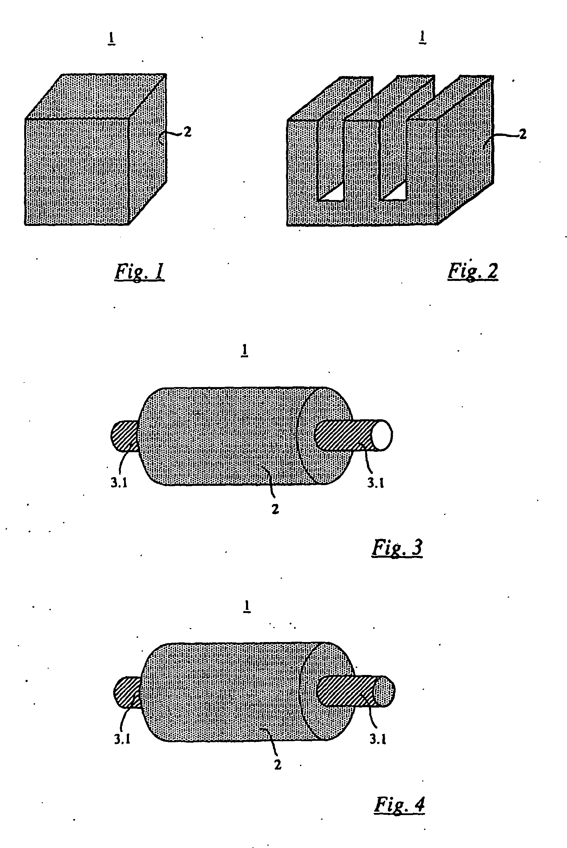

Fig. 1 zeigt schematisch eine Ausführungsform eines erfindungsgemäßen Wärmetauschers 1, der aus offenporigem. Metallschaum 2 gebildet ist. Der offenporige Metallschaum 2 weist eine würfelförmige Gestalt auf.
Fig. 2 zeigt schematisch eine zweite Ausführungsform eines erfindungsgemäßen Wärmetauschers, der aus offenporigem Metallschaum 2 gebildet ist. Der offenporige Metallschaum 2 weist eine kammartige Struktur auf.
Fig. 3 zeigt schematisch eine dritte Ausführungsform eines erfindungsgemäßen Wärmetauschers 1, der aus offenporigem Metallschaum 2 gebildet ist. Der offenporige Metallschaum 2 weist eine rohrförmige Gestalt auf. An den Metallschaum 2 sind Zu- und Ableitungsrohre 3.1 angegossen.
Fig. 4 zeigt schematisch eine vierte Ausführungsform eines erfindungsgemäßen Wärmetauschers 1, der aus offenporigem Metallschaum 2 gebildet ist. Der offenporig Metallschaum 2 weist eine rohrförmige Gestalt auf. An den Metallschaum 2 sind Zu- und Ableitungsrohre 3.1 angegossen. Im Gegensatz zu der in Fig. 3 dargestellten Ausführungsform sind Zu- und Ableitungsrohre 3.1 mit einer offenporigen Struktur ausgestattet.

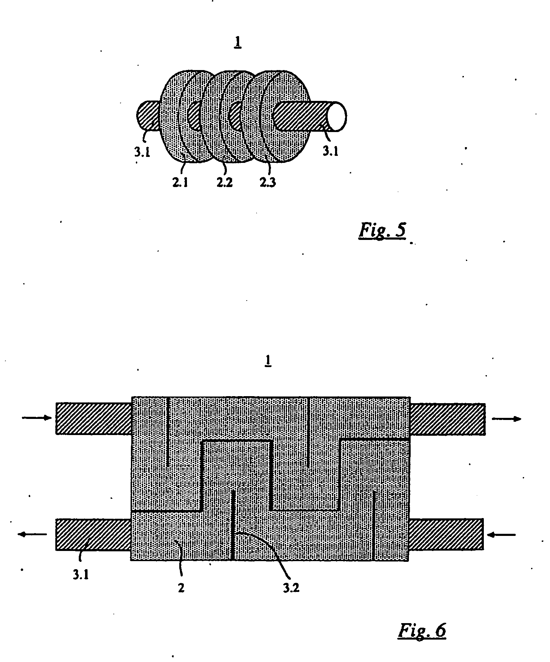

Fig. 5 zeigt schematisch eine fünfte Ausführungsform eines erfindungsgemäßen Wärmetauschers 1, der aus offenporigem Metallschaum 2 gebildet ist. Der offenporige Metallschaum 2 ist in Segmente 2.1, 2.2, 2.3 unterteilt. An die Segmente 2.1, 2.2, 2.3 sind Zu- und Ableitungsrohre 3.1 angegossen, die die Segmente 2.1, 2.2, 2.3 miteinander verbinden.
Fig. 6 zeigt schematisch eine sechse Ausführungsform eines erfindungsgemäßen Wärmetauschers 1, der aus offenporigem Metallschaum 2 gebildet ist. Der offenporige Metallschaum 2 ist durch Trennwände 3.2 so strukturiert, das die über die Zu- und Ableitungsrohre 3.1 strömenden Medien im Gegenstrom zueinander geführt werden.

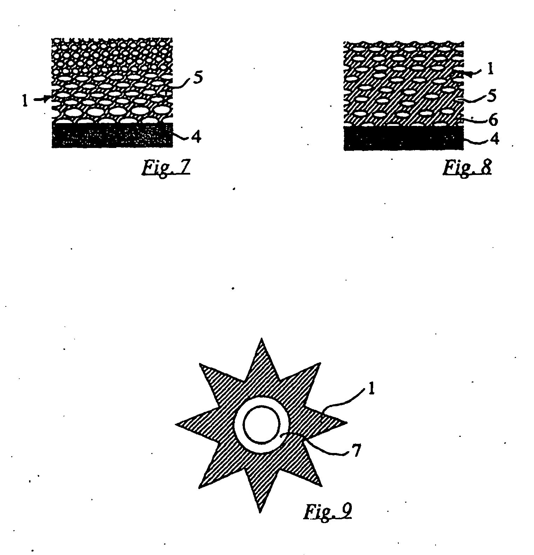

Fig. 7 veranschaulicht, die Gradierung des Metallschaums 2, der den Wärmetauscher 1 bildet Ausgehend von einer Grundplatte 4, die keine Poren aufweist (Vollmaterial), nimmt die Größe der Poren 5 ab.
Fig. 8 veranschaulicht, die Veränderung der Stärke der Stege 6, die die Zellen des Metallschaums 2 für den Wärmetauscher bilden. Ausgehend von einer Grundplatte 4, die keine Poren aufweist (Vollmaterial), nimmt die Stärke der Stege 6 mit zunehmender Entfernung von der Grundplatte 4 ab.
Fig. 9 zeigt schematisch eine siebente Ausführungsform eines erfindungsgemäßen Wärmetauschers 1 im Querschnitt, der aus offenporigem Metallschaum 2 gebildet ist. Der offenporige Metallschaum umschließt ein Rohr 7.

Die Außenfläche des, Metallschaums 2 weist Einbuchtungen auf, die einen besseren Abtransport der Wärme ermöglichen.

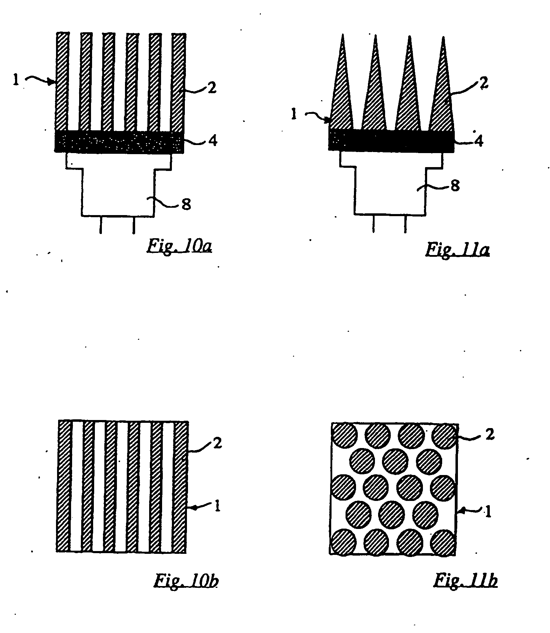

Die Figuren 10 und 11 zeigen Wärmetauscher für Transistoren 8, die unterschiedlich strukturiert sind; jeweils von der Seite (Fig. 10a bzw. 11a) und als Draufsicht (Fig. 10b bzw. 11b).

Zudem zeigen
Fig. 12 einen Wärmetauscher aus offenporigem Metallschaum mit zwei Wärmeverteilern;
Fig. 13 einen Wärmetauscher mit stärker strukturierter Wärmeverteileroberfläche;
Fig. 14 einen Wärmetauscher mit Strukturen in der Wärmeverteileroberfläche, in die Rohre eingebettet sind;
Fig. 15 einen Wärmetauscher mit einem plattenförmigen Wärmeverteiler, auf den eine plattenförmige Deckschicht aufgebracht ist;
Fig. 16 einen Wärmetauscher mit einem plattenförmigen Wärmeverteiler, auf den eine Deckschicht mit strukturierter Oberfläche aufgebracht ist; und
Fig. 17 einen Wärmetauscher mit segmentiertem Metallschaum.

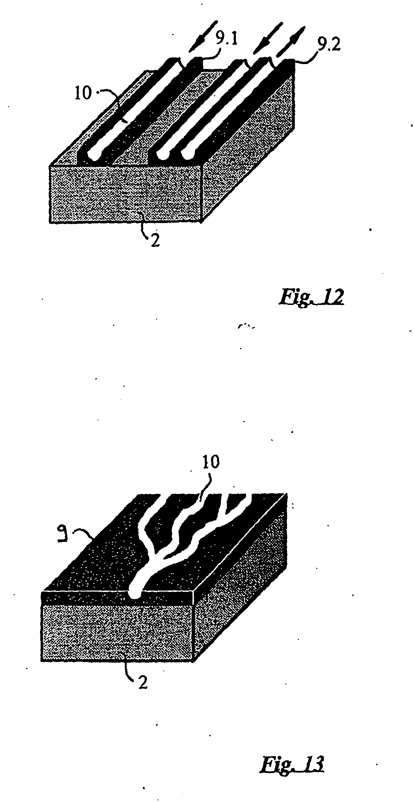

Der in Fig. 12 gezeigte Wärmetauscher besteht aus dem offenporigen Metallschaum 2, an den ein Wärmeverteiler 9 stoffschlüssig angegossen ist. Der Wärmeverteiler besteht aus einem Steg 9.1 und einer Platte 9.2. Steg 9.1 und Platte 9.2 weisen kanalartige Vertiefungen auf, die die Strukturierung 10 bilden. Durch die Struktur 10 strömt ein geeignetes fluides Medium (Pfeile) im Gegen stromprinzip.

Der in Fig. 13 dargestellte Wärmetauscher weist eine komplexere Strukturierung 10 auf, die mäanderartig ausgeführt ist.

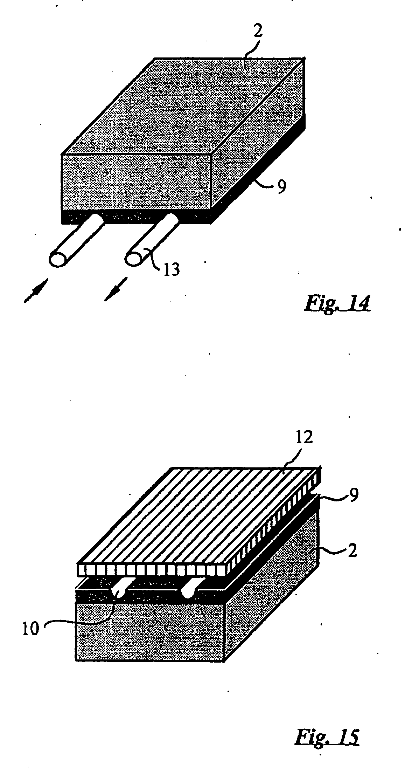

In Fig. 14 sind Rohre 11 gezeigt, die in die Strukturen in der Oberfläche des Wärmeverteilers 9 eingebettet sind. Die Rohre 11 werden von einem geeigneten fluides Medium (Pfeile) durchströmt.

Fig. 15 zeigt einen Wärmetauscher, dessen kanalartig strukturierte Wärmeverteileroberfläche von einer plattenförmigen, unstrukturierten Deckschicht 12 überdeckt ist.

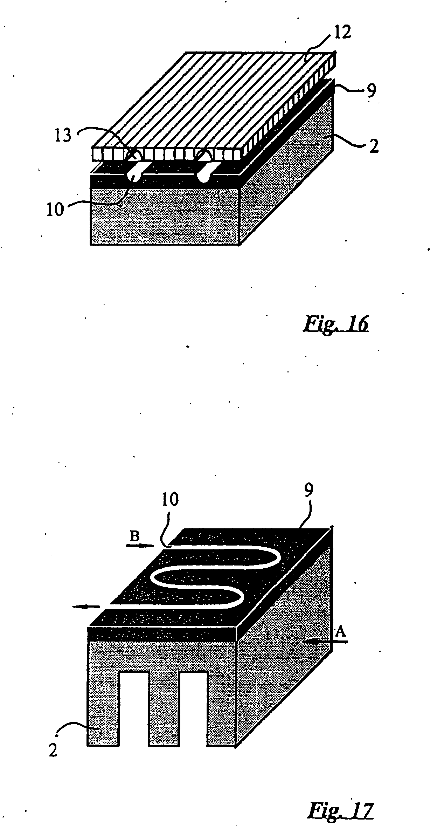

Fig. 16 zeigt einen Wärmetauscher, dessen kanalartig strukturierte Wärmererteileroberfläche von einer Deckschicht 12 überdeckt ist. Die Decksicht 12 weist eine Strukturierung 13 auf, die spiegelbildlich zu der Strukturierung 10 des Wärmeverteilers 9 an der dem Wärmeverteiler 9 zugewandten Oberfläche der Deckschicht 12 ausgebildet ist.

Fig. 17 zeigt einen Wärmeaustauscher mit segmentiertem Metallschaum 2. Der Metallschaum 2 wird von einem fluiden Medium A (Pfeil A) durchströmt, während ein anderes fluides Medium B (Pfeil B) durch die kanalartige Struktur 10 des Wärmverteilers 9 strömt. Ist Medium B das Medium mit der höheren Temperatur, wird dessen Wärme durch den Wärmeverteiler 9 in den Metallschaum 2 geleitet, wo sie von dem fluiden Medium A aufgenommen und aus dem Wärmetauscher ausgetragen wird. Das fluide Medium A kann beispielsweise von einem Lüfter (nicht gezeigt) bewegt werden.

Namentlich im Hinblick auf die Kühlung elektronischer Bauteile ist vorgesehen, daß ein Lüfter für eine erzwungene Konvektion in dem Metallschaum 2 eingebracht ist; diese umschlossene Bauweise ist gepaart mit einer nachhaltigen Geräuschdämmung.

Des weiteren kann die Oberfläche des Metallschaumes 2 mit Nanopartikeln beschichtet sein, um eine Oberflächenvergrößerung zu erreichen und/oder eine Verschmutzung des Metallschaumes infolge des Lotuseffektes zu vermeiden.

Die verwendeten Bezugszeichen bedeuten
- 1: Wärmetauscher
- 2: offenporiger Metallschaum
- 2.1, 2.2, 2.3: Segmente aus offenporigem Metallschaum
- 3.1: Zu- und Ableitungsrohre
- 3.2: Trennwände
- 4: Grundplatte
- 5: Poren
- 6: Stege
- 7: Rohr
- 8: Transistor
- 9: Wärmeverteiler
- 9.1: Steg
- 9.2: Platte
- 10: Struktur bzw. Strukturierung des Wärmeverteilers
- 11: Rohre
- 12: Deckschicht
- 13: Struktur bzw. Strukturierung der Deckschicht

## Patentansprüche

1. Wärmetauscher, bestehend aus offenporigem Metallschaum (2) und zumindest einem Wärmeverteiler, der an den Metallschaum (2) stoffschlüssig angebunden ist, wobei die dem Metallschaum (2) abgewandte Oberfläche des Wärmeverteilers (9) derart strukturiert ist, dass kanalförmige Strukturen (10) auf der Oberfläche des Wärmeverteilers (9) ausgebildet sind, die dem Durchfluss eines flüssigen Mediums dienen.

2. Wärmetauscher nach Anspruch 1, **dadurch gekennzeichnet, dass** in die auf der Oberfläche des Wärmeverteilers (9) ausgebildeten Strukturen (10) Rohre (11) eingebracht sind.

3. Wärmetauscher nach Anspruch 2, **dadurch gekennzeichnet, dass** die Rohre (11) in die Strukturen (10) auf der Oberfläche des Wärmeverteilers (9) eingelötet, eingepresst oder eingeklebt sind.

4. Wärmetauscher nach einem der vorstehenden Ansprüche, **dadurch gekennzeichnet, dass** der Wärmeverteiler (9) als Steg (9.1) oder als Platte (9.2) ausgebildet ist.

5. Wärmetauscher nach einem der vorstehenden Ansprüche, **dadurch gekennzeichnet, dass** der Wärmeverteiler (9) aus Vollmetall besteht.

6. Wärmetauscher nach einem der vorstehenden Ansprüche, **dadurch gekennzeichnet, dass** er mit dem offenporigen Metallschaum (2) in Verbindung stehende Bauelemente, beispielsweise Rohre, aufweist, die mit dem offenporigen Metallschaum in einem Stück gegossen sind, so dass die Bauelemente stoffschlüssig mit dem Metallschaum verbunden sind.

7. Wärmetauscher nach einem der vorstehenden Ansprüche, **dadurch gekennzeichnet, dass** sich das Volumen der in dem Metallschaum (2) enthaltenen Poren mit zunehmender Entfernung vom Eintrittsort des abzuführenden Wärmestromes in den Metallschaum (2) verändert.

8. Wärmetauscher nach einem der vorstehenden Ansprüche, **dadurch gekennzeichnet, dass** das Volumen der in dem Metallschaum (2) enthaltenen Poren mit zunehmender Entfernung vom Eintrittsort des abzuführenden Wärmestromes zunimmt.

9. Wärmetauscher nach einem der vorstehenden Ansprüche, **dadurch gekennzeichnet, dass** das Volumen der in dem Metallschaum (2) enthaltenen Poren mit zunehmender Entfernung vom Eintrittsort des abzuführenden Wärmestromes abnimmt.

10. Wärmetauscher nach einem der vorstehenden Ansprüche, **dadurch gekennzeichnet, dass** die Wandstärke der zwischen den Poren befindlichen Metallstege mit zunehmender Entfernung vom Eintrittsort des abzuführenden Wärmestromes abnimmt.

11. Wärmetauscher nach einem der vorstehenden Ansprüche, **dadurch gekennzeichnet, dass** der Metallschaum (2) aus Aluminium besteht.

12. Wärmetauscher nach einem der vorstehenden Ansprüche, **dadurch gekennzeichnet, dass** der Wärmeverteiler (9) aus Aluminium, Kupfer oder Stahl besteht.

13. Wärmetauscher nach einem der vorstehenden Ansprüche, **dadurch gekennzeichnet, dass** der Wärmeverteiler (9) mit einer Deckschicht (12) verbunden ist.

14. Wärmetaucher nach Anspruch 13, **dadurch gekennzeichnet, dass** die dem Wärmeverteiler (9) zugewandte Oberfläche der Deckschicht (12) eine zu der Struktur (10) in der Oberfläche des Wärmeverteilers (9) spiegelbildliche Struktur (13) aufweist.

15. Wärmetauscher nach Anspruch 13 oder 14, **dadurch gekennzeichnet, dass** die Deckschicht (12) eine feinere Strukturierung (13) als der Wärmeverteiler (9) aufweist.

16. Wärmetauscher nach einem der Ansprüche 13 bis 15, **dadurch gekennzeichnet, dass** die Deckschicht (12) aus demselben Material wie der Wärmeverteiler (9) besteht.

17. Wärmetauscher nach einem der vorstehenden Ansprüche, **dadurch gekennzeichnet, dass** die Strukturen (10, 13) in der Oberfläche des Wärmeverteiler (9) und/oder der Deckschicht (12) durch Beschichtungen verfeinert sind.

18. Wärmetauscher nach einem der vorstehenden Ansprüche, **dadurch gekennzeichnet, dass** der Metallschaum (2) einen Lüfter für eine erzwungene Konvektion umschließt.

19. Wärmetauscher nach einem der vorstehenden Ansprüche, **dadurch gekennzeichnet, dass** die Oberfläche des Metallschaums (2) mit Nanopartikeln beschichtet ist.

## Claims

1. Heat exchanger, comprising open-pore metal foam (2) and at least one heat distributor with a bonded joint to the metal foam (2), wherein the surface of the heat distributor (9) facing away from the metal foam (2) is structured such that channel-like structures (10) are formed on the surface of the heat distributor (9) and permit the passage of a liquid medium.

2. Heat exchanger according to Claim 1, **characterised in that** tubes (11) are placed in the structures (10) formed on the surface of the heat distributor (9).

3. Heat exchanger according to Claim 2, **characterised in that** the tubes (11) are soldered, pressed or glued into the structures (10) on the surface of the heat distributor (9).

4. Heat exchanger according to one of the above Claims, **characterised in that** the heat distributor (9) is formed as a web (9.1) or as a plate (9.2).

5. Heat exchanger according to one of the above Claims, **characterised in that** the heat distributor (9) is of solid metal.

6. Heat exchanger according to one of the above Claims, **characterised in that** it possesses components, for example tubes, in contact with the open-pore metal foam (2) which are cast in a single piece with the open-pore metal foam such that the components form a bonded joint with the metal form.

7. Heat exchanger according to one of the above Claims, **characterised in that** the volume of the pores in the metal foam (2) changes with increasing distance from the point of entry of the heat flow into the metal foam (2).

8. Heat exchanger according to one of the above Claims, **characterised in that** the volume of the pores in the metal foam (2) increases with increasing distance from the point of entry of the heat flow to be dissipated.

9. Heat exchanger according to one of the above Claims, **characterised in that** the volume of the pores in the metal foam (2) decreases with increasing distance from the point of entry of the heat flow to be dissipated.

10. Heat exchanger according to one of the above Claims, **characterised in that** the wall thickness of the metal forming the pores decreases with increasing distance from the point of entry of the heat flow to be dissipated.

11. Heat exchanger according to one of the above Claims, **characterised in that** the metal foam (2) is of aluminium.

12. Heat exchanger according to one of the above Claims, **characterised in that** the heat distributor (9) is of aluminium, copper or steel.

13. Heat exchanger according to one of the above Claims, **characterised in that** the heat distributor (9) is joined to a cover layer (12).

14. Heat exchanger according to Claim 13, **characterised in that** the surface of the cover layer (12) facing the heat distributor (9) displays a structure (13) which is the mirror image of the structure (10) in the surface of the heat distributor (9).

15. Heat exchanger according to Claim 13 or 14, **characterised in that** the cover layer (12) displays a finer structure (13) than the heat distributor (9).

16. Heat exchanger according to one of the Claims 13 to 15, **characterised in that** the cover layer (12) is of the same material as the heat distributor (9).

17. Heat exchanger according to one of the above Claims, **characterised in that** the structures (10, 13) in the surface of the heat distributor (9) and/or of the cover layer (12) are refined by way of coatings.

18. Heat exchanger according to one of the above Claims, **characterised in that** the metal foam (2) encloses a fan for forced convection.

19. Heat exchanger according to one of the above Claims, **characterised in that** the surface of the metal foam (2) is coated with nano-particles.

## Revendications

1. Échangeur de chaleur composé de mousse métallique à pores ouverts (2) et d'au moins un distributeur de chaleur assemblé avec la mousse métallique (2) par la matière, la surface de la face du distributeur de chaleur (9), située du côté opposé à la mousse métallique (2), étant structurée de sorte à former des structures en forme de canaux (10) à la surface du distributeur de chaleur (9), ces canaux étant utilisés pour la circulation d'un liquide.

2. Échangeur de chaleur selon la revendication 1, **caractérisé en ce que** des tubes (11) sont intégrés dans les structures (10) formées à la surface du distributeur de chaleur (9).

3. Échangeur de chaleur selon la revendication 2, **caractérisé en ce que** les tubes (11) sont soudés, sertis ou collés dans les structures (10) formées à la surface du distributeur de chaleur (9).

4. Échangeur de chaleur selon l'une des revendications précédentes, **caractérisé en ce que** le distributeur de chaleur (9) est réalisé en forme de barre (9.1) ou de plaque (9.2).

5. Échangeur de chaleur selon l'une des revendications précédentes, **caractérisé en ce que** le distributeur de chaleur (9) est réalisé en métal massif.

6. Échangeur de chaleur selon l'une des revendications précédentes, **caractérisé en ce qu'**il possède des éléments reliés à la mousse métallique à pores ouverts (2), tels que des tubes, ces éléments étant moulés d'une pièce avec la mousse métallique à pores ouverts de sorte que ces éléments soient assemblés avec la mousse métallique par la matière.

7. Échangeur de chaleur selon l'une des revendications précédentes, **caractérisé en ce que** le volume des pores de la mousse métallique (2) varie plus ceux-ci s'éloignent de l'endroit où le flux de chaleur à évacuer pénètre dans la mousse métallique (2).

8. Échangeur de chaleur selon l'une des revendications précédentes, **caractérisé en ce que** le volume des pores de la mousse métallique (2) augmente plus ceux-ci s'éloignent de l'endroit où le flux de chaleur à évacuer pénètre dans la mousse métallique (2).

9. Échangeur de chaleur selon l'une des revendications précédentes, **caractérisé en ce que** le volume des pores de la mousse métallique (2) diminue plus ceux-ci s'éloignent de l'endroit où le flux de chaleur à évacuer pénètre dans la mousse métallique (2).

10. Échangeur de chaleur selon l'une des revendications précédentes, **caractérisé en ce que** l'épaisseur des parois séparant les pores diminue plus ceux-ci s'éloignent de l'endroit où le flux de chaleur à évacuer pénètre dans la mousse métallique (2).

11. Échangeur de chaleur selon l'une des revendications précédentes, **caractérisé en ce que** la mousse métallique (2) est réalisé en aluminium.

12. Échangeur de chaleur selon l'une des revendications précédentes, **caractérisé en ce que** le distributeur de chaleur (9) est réalisé en aluminium, en cuivre ou en acier.

13. Échangeur de chaleur selon l'une des revendications précédentes, **caractérisé en ce que** le distributeur de chaleur (9) est réalisé avec une couche superficielle.

14. Échangeur de chaleur selon la revendication 13, **caractérisé en ce que** la surface de la couche superficielle (12), située du côté du distributeur de chaleur (9), présente une structure (13) inversée par rapport à la structure (10) de la surface du distributeur de chaleur (9).

15. Échangeur de chaleur selon la revendication 13 ou 14, **caractérisé en ce que** la couche superficielle (12) présente une structure (15) plus fine que le distributeur de chaleur (9).

16. Échangeur de chaleur selon les revendications 13 à 15, **caractérisé en ce que** la couche superficielle (12) est composée du même matériau que le distributeur de chaleur (9).

17. Échangeur de chaleur selon l'une des revendications précédentes, **caractérisé en ce que** les structures (10, 13) de la surface du distributeur de chaleur (9) et/ou de la couche superficielle (12) sont affinées par des enduits.

18. Échangeur de chaleur selon l'une des revendications précédentes, **caractérisé en ce que** la mousse métallique (2) entoure un ventilateur pour la convection forcée.

19. Échangeur de chaleur selon l'une des revendications précédentes, **caractérisé en ce que** la surface de la mousse métallique (2) est enduite de nanoparticules.
